# EUROPÄISCHE PATENTSCHRIFT

(11) **EP 0 493 379 B1**
(45) Veröffentlichungstag und Bekanntmachung des Hinweises auf die Patenterteilung: **24.08.1994**
(21) Anmeldenummer: 90900139.8
(22) Anmeldetag: 15.12.1989
(51) Int. Cl.: H03K 17/73

(54) **AUSSCHALTKREIS EINER ANSTEUERSCHALTUNG FÜR EINEN GATEGESTEUERTEN HALBLEITER**
SWITCH-OFF CIRCUIT OF A CONTROL CIRCUIT FOR A GATE-CONTROLLED SEMICONDUCTOR
CIRCUIT D'ARRET D'UN CIRCUIT D'ACTIVATION POUR UN SEMICONDUCTEUR COMMANDE PAR GRILLE

(30) Priorität: 22.09.1989 DE 3931743
(43) Veröffentlichungstag der Anmeldung: 08.07.1992
(73) Patentinhaber: SIEMENS AKTIENGESELLSCHAFT, 80333 München (DE)
(72) Erfinder: MARQUARDT, Rainer, D-8520 Erlangen (DE)
(86) Internationale Anmeldenummer: EP8901552
(87) Internationale Veröffentlichungsnummer: WO9104608

(56) Entgegenhaltungen:
- EP-A- 243 844
- DE-A- 3 517 467

## Beschreibung

Die Erfindung bezieht sich auf einen Ausschaltkreis einer Ansteuerschaltung für einen gategesteuerten Halbleiter, der in Abhängigkeit von einem Einschaltbefehl bzw. einem Ausschaltbefehl in einen stromleitenden bzw. einen stromsperrenden Schaltzustand steuerbar ist, wobei der Ausschaltkreis aus einer Reihenschaltung einer Steuerkreisinduktivität und einer steuerbaren Kondensatorbatterie besteht, wobei die freien Klemmen dieser Reihenschaltung die Ausangsklemmen des Ausschaltkreises bilden und wobei die steuerbare Kondensatorbatterie aus wenigstens einem Halbleiterschalter und einem Kondensator besteht.

Eine derartige Ansteuerschaltung ist aus der Zeitschrift "Elektrotechnik", 64, Heft 24, 17. Dezember 1982, Seiten 16 bis 21, bekannt.

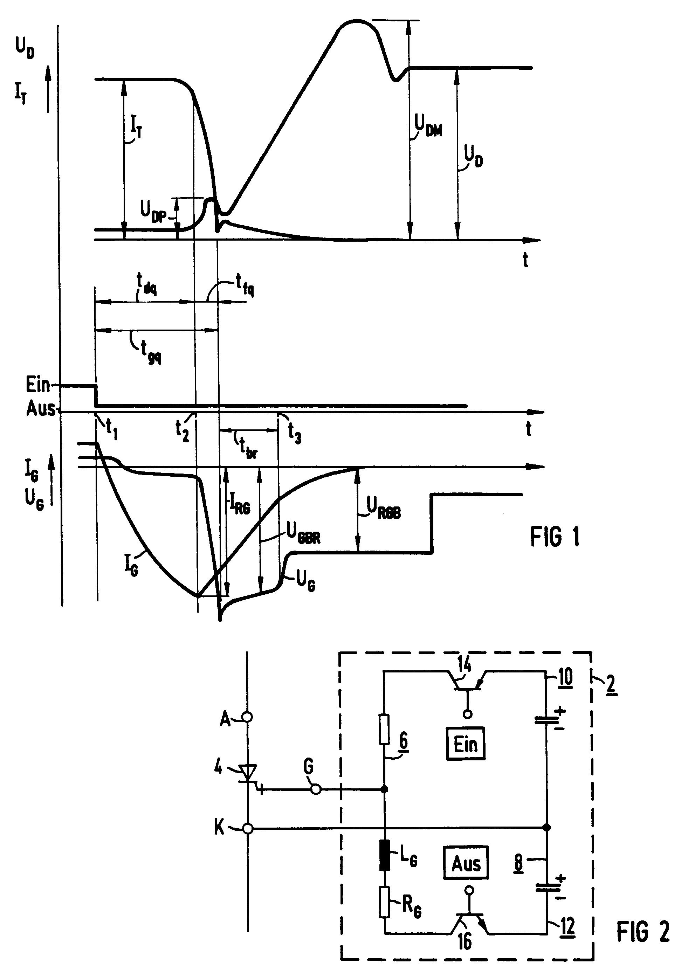

Unter gategesteuerten Halbleitern sollen hier ausschaltbare Thyristoren (Gate Turn-Off-Thyristoren, auch GTO-Thyristoren genannt) oder andere, ähnliches Verhalten aufweisende Halbleiterschalter verstanden sein, mit denen größere Ströme geschaltet werden. Die Spannungs- und Stromverhältnisse im Anoden-Kathodenkreis sowie im Gate-Kathodenkreis beim Ausschalten eines GTO-Thyristors ist in Figur 1 zusammen mit dem zeitlichen Verlauf des Schaltbefehls dargestellt. Mit dem Umschalten des Schaltbefehls von "EIN" auf "AUS" wird durch die Ansteuerschaltung, insbesondere dem Ausschaltkreis, ein negativer Gate-Strom I_{G} über die Gate-Kathodenstrecke des GTO-Thyristors getrieben.

Der Gate-Stron I_{G} steigt bis zu einer Gate-Rückwärtssteuerstromspitze I_{RG} an, um dann wieder auf Null abzufallen. Bei Erreichen dieser Gate-Rückwärtssteuerstromspitze I_{RG} springt die Gate-Spannung U_{G} steil an, um dann schließlich auf die Gate-Rückwärtssteuerspannung U_{RGB} abzufallen. Während des Abschaltvorgangs fließt zunächst im Anoden-Kathodenkreis des GTO-Thyristors der Anodenstrom I_{T} weiter, bis er schließlich im zeitlichen Bereich der Gate-Rückwärtssteuerstromspitze I_{RG} steil auf einen sogenannten Schweifstrom abfällt. Die Zeit von der Abgabe des "AUS"-Schaltbefehls bis zum steilen Abfall des Anodenstroms wird als Abschaltverzugszeit t_{dq} bezeichnet. Die Zeit des Abfalls des Anodenstroms I_{T} bis zum Schweifstrom bezeichnet man als Abschaltfallzeit t_{fq}. Die Summe aus der Abschaltverzugszeit t_{dq} und der Abschaltfallzeit t_{fq} ist die Abschaltzeit t_{gq} des GTO-Thyristors. Die Gleichspannung U_{D} am GTO-Thyristor steigt während der Abfallzeit des Anodenstroms I_{T} zunächst auf den Wert der sogenannten Nadelspannung U_{DP}, um dann im weiteren Verlauf des Abschaltvorganges bis zu der Spitzenspannung U_{DM} anzusteigen. Im abgeschalteten Zustand liegt am GTO-Thyristor schließlich dann die Gleichspannung U_{D}.

Um die für das Abschalten erforderliche hohe negative Gate-Rückwärtssteuerstromspitze I_{RG} mit steilem Anstieg zu erzeugen, sollte die Spannungsquelle des Ausschaltkreises der Ansteuerschaltung einen sehr niedrigen Innenwiderstand haben. Ferner ist darauf zu achten, daß die auftretende negative Steuerspannung U_{RG} zugunsten eines guten Abschaltverhaltens groß gewählt wird, jedoch den höchstzulässigen Wert der Gate-Rückwärtssteuerspannung U_{RGM} nicht für eine längere Zeit überschreitet. Nur für eine kurze Zeit t_{br} ist die Beanspruchung mit negativer Steuerspannung im Avalanchebereich der Gate-Kathoden-Strecke zulässig. Bei dem bekannten Ausschaltkreis ist als Spannungsquelle eine Kathodenbatterie vorgesehen. Um die genannten Bedingungen zu erfüllen, werden Kondensatoren hoher Kapazität und niedriger Spannung, beispielsweise 10 mF/16 V, verwendet. Aufgrund des Raumbedarfs werden Elektrolyt-Kondensatoren verwendet. Diese haben jedoch bei höheren Umgebungstemperaturen eine sehr begrenzte Lebensdauer und bei niedrigen Umgebungstemperaturen stark ansteigende, parasitäre Serienwiderstände.

Aus der DE 35 17 467 A1 ist eine Schaltungsanordnung für den Abschaltsteuerkreis eines GTO-Thyristors bekannt. Im Abschaltsteuerkreis für den GTO-Thyristor ist ein Impulstransformator angeordnet, dessen Sekundärwicklung über Entkopplungsdioden zwischen den Steueranschluß und die Kathode des GTO-Thyristors gelegt ist. Dessen Primärwicklung ist während der gesamten Dauer des Abschaltvorgangs des GTO-Thyristors über ein erstes Schaltelement mit einer ersten Spannungsquelle verbunden. An dieser Primärwicklung ist eine zweite Spannungsquelle angeschlossen, deren Spannung über ein zweites Schaltelement der Spannung der ersten Spannungsquelle vom Beginn des Abschaltvorgangs an für eine wesentlich geringere Zeit als die Gesamtdauer des Abschaltvorgangs aufgeschaltet ist. Dadurch wird erreicht, daß die Spannungszeitfläche des Impulstransformators sich verringert, wodurch der Transformator mit kleinerer Streuinduktivität aufgebaut werden kann.

Aus der EP O 243 844 A3 ist ebenfalls ein Verfahren und eine Schaltungsanordnung zum Ausschalten eines GTO-Thyristors bekannt, wobei keine RCD-Schutzbeschaltung für den GTO-Thyristor vorgesehen ist. Der Ausschaltkreis enthält zwei negative Spannungsquellen, die jeweils über einen Schalter mit dem Gate und der Kathode des GTO-Thyristors verbindbar sind. Der Spannungswert der zweiten negativen Spannungsquelle ist größer als die Avalanchespannung. Diese Spannungsquelle bleibt solange in der Gate-Kathoden-Strecke des GTO-Thyristors bis ein kapazitiver Effekt der Anoden-Gate-Strecke verschwunden ist. Dann wird diese zweite negative Spannungsquelle in ausreichender Zeit ausgeschaltet, um den Thyristor nicht übermäßig zu erhitzen. Mittels der ersten negativen Spannunsquelle wird der GTO-Thyristor im Ausschalt-Zustand gehalten. Mittels dieses Verfahrens kann die Stromansteigsgeschwindigkeit des Gate-Stromes vergrößert werden bei gleichzeitiger Erhöhung der verwendeten Spannung.

Der Erfindung liegt nun die Aufgabe zugrunde, die steuerbare Kondensatorbatterie des Ausschaltkreises der Ansteuerschaltung dahingehend zu verbessern, daß die Spannung der Kondensatorbatterie wesentlich erhöht wird.

Diese Aufgabe wird erfindungsgemäß dadurch gelöst, daß die steuerbare Kondensatorbatterie einen Freilaufzweig aufweist und daß zu den Ausgangsklemmen des Ausschaltkreises eine Reihenschaltung, bestehend aus einer Entkopplungsdiode und einer weiteren steuerbaren Kondensatorbatterie, elektrisch parallel geschaltet ist, wobei die steuerbare Kondensatorbatterie nach Beginn des Löschvorgangs des gategesteuerten Halbleiters wieder aus- und die weitere steuerbare Kondensatorbatterie eingeschaltet werden, sobald die Gate-Spannung einen vorbestimmten negativen Schwellspannungswert überschreitet.

Durch diesen Aufbau des Ausschaltkreises der Ansteuerschaltung für einen gategesteuerten Halbleiter und der ablösenden Spannungsversorgung in Abhängigkeit eines negativen Schwellspannungswertes wird erreicht, daß die Kondensatorspannung der steuerbaren Kondensatorbatterie wenigstens gleich der doppelten Gatedurchbruchspannung gegenüber annähernd zwei Drittel der Gatedurchbruchspannung gewählt werden kann. Dadurch kann bei gleichem Energieinhalt der Kondensatorbatterie der Wert der Kapazität auf ungefähr ein Neuntel des Wertes der bisherigen Kapazität reduziert werden, wodurch keine Elektrolyt-Kondensatoren mehr verwendet werden müssen. Zuverlässiger sind Kunststoffolien-Kondensatoren, die einen größeren Temperatureinsatzbereich aufweisen. Außerdem wird der störende Einfluß parasitärer Serienwiderstände im Ausschaltkreis durch die höhere Kondensatorspannung stark reduziert, wodurch höhere, steile Gate-Ströme möglich werden.

Bei einer besonders vorteilhaften Ausgestaltung des Ausschaltkreises ist als steuerbare Kondensatorbatterie eine gesteuerte Brückenschaltung vorgesehen, deren gleichstromseitige Anschlüsse über einen Kondensator und deren wechselstromseitige Anschlüsse über eine Primärwicklung eines Ringkerntransformators elektrisch leitend miteinander verbunden sind. Außerdem besteht der Freilaufzweig aus einer Reihenschaltung einer Diode und einer Sekundärwicklung des Ringkerntransformators. Durch diese besonders vorteilhafte Ausgestaltung erhält man eine galvanische Trennung zwischen der steuerbaren Kondensatorbatterie und dem gategesteuerten Halbleiter. Dadurch kann die Kondensatorspannung der steuerbaren Kondensatorbatterie auf ein Vielfaches der Gatedurchbruchspannung erhöht werden. Durch die Verwendung des Ringkerntransformators wird außerdem erreicht, daß die Schalter der steuerbaren Kondensatorbatterie nur noch für einen Bruchteil des Gate-Stroms ausgelegt werden müssen.

Zur weiteren Erläuterung der Erfindung wird auf die Zeichnung Bezug genommen, in der Ausführungsbeispiele des erfindungsgemäßen Ausschaltkreises schematisch veranschaulicht sind.
- Figur 2: zeigt eine bekannte Ansteuerschaltung für einen gategesteuerten Halbleiter, in
- Figur 3: ist eine Ausführungsform des erfindungsgemäßen Ausschaltkreises einer Ansteuerschaltung dargestellt und
- Figur 4: veranschaulicht eine besonders vorteilhafte Ausführungsform des erfindungsgemäßen Ausschaltkreises.

Figur 2 zeigt ein aus der Zeitschrift "Elektrotechnik",64,Heft 24,17. Dezember 1982, Seiten 16 bis 21, bekanntes Prinzipschaltbild einer Ansteuerschaltung 2 für einen gategesteuerten Halbleiter 4. Die Ansteuerschaltung 2 wird auch als Steuergenerator bezeichnet, der einen Einschaltkreis 6 und einen Ausschaltkreis 8 enthält. Als gategesteuerter Halbleiter 4 ist ein Abschaltthyristor oder auch ein GTO-Thyristor vorgesehen. Der Einschaltkreis 6 bzw. der Ausschaltkreis 8 enthält eine positive bzw. eine negative steuerbare Kondensatorbatterie 10 bzw. 12. In Abhängigkeit von einem Einschaltbefehl "EIN" bzw. einem Ausschaltbefehl "AUS" wird ein Halbleiterschalter 14 bzw. 16 der steuerbaren Kondensatorbatterie 10 bzw. 12 durchgesteuert, wodurch der GTO-Thyristor 4 in einen stromleitenden bzw. einen stromsperrenden Schaltzustand steuerbar ist. Der Ausschaltkreis 8 weist noch eine Steuerkreisinduktivität L_{G} auf, die dafür sorgt, daß der negative Steuerstrom I_{G} während der Abschaltzeit t_{gq} nicht zu schnell abnimmt und dadurch den Abschaltvorgang ungünstig beeinflußt. Jedoch muß eine zu große Induktivität L_{G} vermieden werden, damit die Steilheit des negativen Gatestromes I_{G} nicht zu gering wird. Mit R_{G} ist der parasitäre Widerstand des Ausschaltkreises 8 bezeichnet.

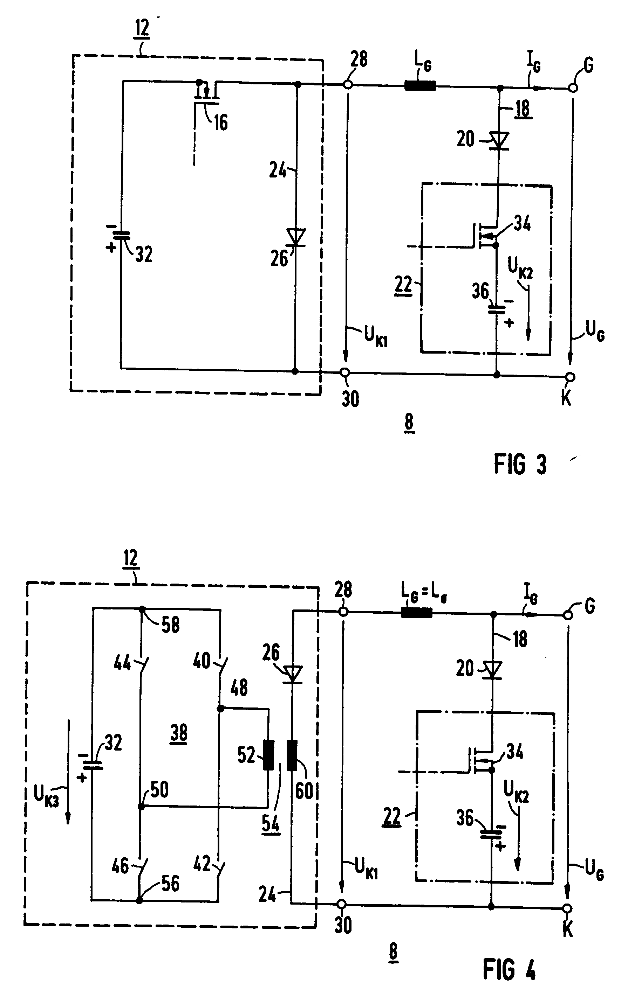

In Figur 3 ist eine einfache Ausgestaltung des erfindungsge mäßen Ausschaltkreises 8 einer Ansteuerschaltung 2 im einzelnen dargestellt. Der Ausschaltkreis 8 besteht aus der steuerbaren Kondensatorbatterie 12, der Steuerkreisinduktivität L_{G} und einer Reihenschaltung 18, die elektrisch parallel zu den Ausgangsklemmen G und K geschaltet ist und die aus einer Entkopplungsdiode 20 und einer weiteren steuerbaren Kondensatorbatterie 22 besteht. Die steuerbare Kondensatorbatterie 12 weist einen Freilaufzweig 24 auf, der eine Diode 26 enthält. An den Ausgangsklemmen 28 und 30 dieser steuerbaren Kondensatorbatterie 12 steht eine Kondensatorspannung U_{K1} an, sobald der Halbleiterschalter 16 mittels des Ausschaltbefehls "AUS" angesteuert wird. Elektrisch in Reihe zum Halbleiterschalter 16 ist ein Kunststoffolien-Kondensator 32, beispielsweise 1 mF / 50 V, geschaltet. Die weitere steuerbare Kondensatorbatterie 22 besteht ebenfalls aus einem Halbleiterschalter 34 und einem Kunststoffolien-Kondensator 36, der beispielsweise 0,1 mF / 16 V. Als Halbleiterschalter 16 und 34 sind Metalloxidschicht-Feldeffekttransistoren (MOS-FETs), insbesondere selbstsperrende n-Kanal-MOS-FETs, vorgesehen. Es können jedoch auch Leistungs-Transistoren oder Thyristoren verwendet werden.

Anhand der dargestellten Verläufe der Gate-Spannung U_{G} und des Gate-Stromes I_{G} soll die Funktionsweise des Ausschaltkreises 8 der Ansteuerschaltung 2 näher beschrieben werden:

Zum Zeitpunkt t₁ schaltet der Schaltbefehl von "EIN" auf "AUS" um, d.h., der Halbleiterschalter 16 wird leitend, wodurch an den Ausgangsklemmen 28 und 30 der steuerbaren Kondensatorbatterie 12 eine Kondensatorspannung U_{K1} ansteht, dessen Wert doppelt so groß ist wie der Wert der Gatedurchbruchspannung U_{GBR} des verwendeten GTO-Thyristors 4. Durch diesen hohen Spannungswert wird ein hoher, steiler negativer Gate-Strom I_{G} erzeugt, der über die Ausgangsklemme G, die Steuerkreisinduktivität L_{G}, den Halbleiterschalter 16, den Kondensator 32, die Ausgangsklemme K und die Gate-Kathoden-Strecke fließt. Zum Zeitpunkt t₂ unterschreitet die Gate-Spannung U_{G} einen vorbestimmten, negativen Schwellspannungswert, wodurch der Halbleiterschalter 16 in den stromsperrenden Schaltzustand und der Halbleiterschalter 34 in den stromleitenden Schaltzustand gesteuert werden. Dadurch fällt der Wert der Kondensatorspannung U_{K1} annähernd auf 0 V. Mittels der durch die Steuerkreisinduktivität L_{G} erzeugte Gegenspannung wird der negative Gate-Strom I_{G} über den Freilaufweg bis zum Zeitpunkt t₃ getrieben. Zwischen den Zeitpunkten t₂ und t₃ nimmt der Gate-Strom I_{G} linear ab. Sobald der Wert der Gegenspannung der Steuerkreisinduktivität L_{G} kleiner ist als der Wert der Kondensatorspannung U_{K2} der weiteren steuerbaren Kondensatorbatterie 22, die bereits zum Zeitpunkt t₂ eingeschaltet wurde, kommutiert der Gate-Strom I_{G} auf die Reihenschaltung 18 (Zeitpunkt t₃). Da nun nur noch eine Spannungsquelle benötigt wird, wodurch der stromsperrende Zustand des GTO-Thyristors 4 aufrechterhalten bleibt, ist der Kapazitätswert des Kondensators 36 sehr viel kleiner als der Kapazitätswert des Kondensators 32.

In Figur 4 ist eine vorteilhafte Ausgestaltung des erfindungsgemäßen Ausschaltkreises 8 dargestellt. Gegenüber der Ausführungsform gemäß Figur 3 ändert sich nur der Aufbau der steuerbaren Kondensatorbatterie 12. Deshalb bezeichnen gleiche Bezugszeichen dieselben Elemente.

Die steuerbare Kondensatorbatterie 12 weist eine gesteuerte Brückenschaltung 38 auf. Diese Brückenschaltung hat entweder zwei gesteuerte und zwei ungesteuerte Stromrichterventile 40, 42 und 44, 46 oder vier gesteuerte Stromrichterventile 40 bis 46. Die wechselstromseitigen Anschlüsse 48 und 50 sind über eine Primärwicklung 52 eines Ringkerntransformators 54 miteinander elektrisch leitend verbunden. Die gleichstromseitigen Anschlüsse 56 und 58 sind über den Kondensator 32 miteinander elektrisch leitend verbunden. Der Freilaufzweig besteht aus einer Reihenschaltung der Diode 26 und einer Sekundärwicklung 60 des Ringkerntransformators 54. Die Steuerkreisinduktivität L_{G} wird bei dieser Ausführungsform durch die Streuinduktivität L_{σ} des Ringkerntransformators 54 gebildet.

Durch diesen Aufbau der steuerbaren Kondensatorbatterie 12 kann der Wert der Kondensatorspannung U_{K3} wesentlich erhöht werden.

Außerdem ist durch die Verwendung des Ringkerntransformators 54 die steuerbare Kondensatorbatterie 12 galvanisch von der Gate-Kathoden-Strecke des GTO-Thyristors 4 getrennt, wodurch die Stromrichterventile 40 bis 46 der gesteuerten Brückenschaltung 38 nur noch für einen Bruchteil des Wertes des negativen Gate-Stromes I_{G} bemessen werden müssen. Durch die noch höhere Kondensatorspannung U_{K3} wird ein noch höherer und steilerer Gate-Strom I_{G} erzeugt, wodurch ein sicheres Abschalten des GTO-Thyristors 4 über einen großen Temperatureinsatzbereich gewährleistet wird. Außerdem wird durch die höhere Kondensatorspannung U_{K3} der Einfluß der parasitären Widerstände erheblich reduziert.

## Patentansprüche

1. Ausschaltkreis (8) einer Ansteuerschaltung (2) für einen gategesteuerten Halbleiter (4), der in Abhängigkeit von einem Einschaltbefehl bzw. einem Ausschaltbefehl in einen stromleitenden bzw. einen stromsperrenden Schaltzustand steuerbar ist, wobei der Ausschaltkreis (8) aus einer Reihenschaltung einer Steuerkreisinduktivität (L_{G}) und einer steuerbaren Kondensatorbatterie (12) besteht, wobei die freien Klemmen dieser Reihenschaltung die Ausgangsklemmen (G, K) des Ausschaltkreises (8) bilden und wobei die steuerbare Kondensatorbatterie (12) aus wenigstens einem Halbleiterschalter (16) und einem Kondensator (32) besteht, **dadurch gekennzeichnet,** daß die steuerbare Kondensatorbatterie (12) einen Freilaufzweig (24) aufweist und daß zu den Ausgangsklemmen (G, K) des Ausschaltkreises (8) eine Reihenschaltung (18), bestehend aus einer Entkopplungsdiode (20) und einer weiteren steuerbaren Kondensatorbatterie (22), elektrisch parallel geschaltet ist, wobei die steuerbare Kondensatorbatterie (12) nach Beginn des Löschvorgangs wieder aus- und die weitere steuerbare Kondensatorbatterie (22) eingeschaltet werden, sobald die Gate-Spannung (U_{G}) einen vorbestimmten negativen Schwellspannungswert unterschreitet.

2. Ausschaltkreis (8) nach Anspruch 1, **dadurch gekennzeichnet,** daß als weitere steuerbare Kondensatorbatterie (22) eine Reihenschaltung, bestehend aus einem Halbleiterschalter (34) und einem Kondensator (36), vorgesehen ist.

3. Ausschaltkreis (8) nach Anspruch 2, **dadurch gekennzeichnet,** daß die Kapazität der weiteren steuerbaren Kondensatorbatterie (22) sehr viel kleiner ist als die Kapazität der steuerbaren Kondensatorbatterie (12).

4. Ausschaltkreis (8) nach Anspruch 1, **dadurch gekennzeichnet,** daß der Freilaufzweig (24) eine Diode (26) enthält.

5. Ausschaltkreis (8) nach Anspruch 1, **dadurch gekennzeichnet,** daß als steuerbare Kondensatorbatterie (12) eine gesteuerte Brückenschaltung (38) vorgesehen ist, deren gleichstromseitige Anschlüsse (56, 58) über einen Kondensator (32) und deren wechselstromseitige Anschlüsse (48, 50) über eine Primärwicklung (52) eines Ringkerntransformators (54) elektrisch leitend miteinander verbunden sind und der Freilaufzweig (24) aus einer Reihenschaltung einer Diode (26) und einer Sekundärwicklung (60) des Ringkerntransformators (54) besteht.

6. Ausschaltkreis (8) nach Anspruch 5, **dadurch gekennzeichnet,** daß die Streuinduktivität (L_{σ}) des Ringkerntransformators (54) als Steuerkreisinduktivität (L_{G}) vorgesehen ist.

## Claims

1. Turn-off circuit (8) of a trigger circuit (2) for a gate-controlled semiconductor (4) which can be set to a current-conducting or a current-blocking switching state as a function of a switch-on command or a switch-off command, respectively, the turn-off circuit (8) comprising a series circuit of a control-circuit inductance (L_{G}) and a controllable capacitor bank (12), the free terminals of said series circuit forming the output terminals (G, K) of the turn-off circuit and the controllable capacitor bank (12) comprising at least one semiconductor switch (16) and a capacitor (32), characterized in that the controllable capacitor bank (12) has a freewheel branch (24) and in that a series circuit (18) comprising a decoupling diode (20) and a further controllable capacitor bank (22) is connected electrically in parallel with the operating terminals (G, K) of the turn-off circuit (8), the controllable capacitor bank (12) being switched off again after the start of the quenching process and the further controllable capacitor bank (22) being switched on as soon as the gate voltage (U_{G}) drops below a predetermined negative threshold value.

2. Turn-off circuit (8) according to Claim 1, characterized in that the further controllable capacitor bank (22) provided is a series circuit comprising a semiconductor switch (34) and a capacitor (36).

3. Turn-off circuit (8) according to Claim 2, characterized in that the capacitance of the further controllable capacitor bank (22) is very much smaller than the capacitance of the controllable capacitor bank (12).

4. Turn-off circuit (8) according to Claim 1, characterized in that the freewheel branch (24) contains a diode (26).

5. Turn-off circuit (8) according to Claim 1, characterized in that the controllable capacitor bank (12) provided is a controlled bridge circuit (38) whose direct-current terminals (56, 58) are connected together in an electrically conducting manner via a capacitor (32) and whose alternating-current terminals (48, 58) are connected together in an electrically conducting manner via a primary winding (52) a toroidal-core transformer (54) and the freewheel branch (24) comprises a series circuit of a diode (26) and a secondary winding (60) of the toroidal-core transformer (54).

6. Turn-off circuit (8) according to Claim 5, characterized in that the stray inductance (L_{δ}) of the toroidal-core transformer (54) is provided as control-circuit inductance (L_{G}).

## Revendications

1. Circuit interrupteur (8) d'un circuit (2) de commande pour un semi-conducteur (4) commandé par grille qui, en fonction d'un ordre de mise à l'état conducteur ou d'un ordre de mise à l'état bloqué, peut être commandé dans un état de commutation conducteur de courant ou non conducteur de courant, le circuit interrpteur (8) étant constitué du circuit série d'une inductance (L_{G}) du circuit de commande et d'une batterie (12) de condensateurs susceptible d'être commandée, les bornes libres de ce circuit série constituant les bornes (G, K) de sortie du circuit interrupteur (8), et la batterie (12) de condensateurs susceptible d'être commandée étant constituée d'au moins un interrupteur (16) à semi-conducteur et d'un condensateur (32), caractérisé en ce que la batterie (12) de condensateurs susceptible d'être commandée comporte une branche (24) de roue libre, et qu'un circuit série (18) constitué d'une diode (20) de découplage et d'une autre batterie (22) de condensateurs susceptible d'être commandée est relié électriquement en parallèle aux bornes (G, K) de sortie du circuit interrupteur (8), la batterie (12) de condensateurs susceptible d'être commandée étant à nouveau coupée et l'autre batterie (22) de condensateurs susceptible d'être commandée, mis en circuit après le début de l'opération d'effacement, dès que la tension (U_{G}) de porte passe au-dessous d'une valeur de tension de seuil négative prescrite.

2. Circuit interrupteur (8) selon la revendication 1, caractérisé en ce qu'en tant que batterie (22) supplémentaire de condensateurs susceptible d'être commandée, il est prévu un circuit série constitué d'un interrupteur (34) à semi-conducteur et d'un condensateur (36).

3. Circuit interrupteur (8) selon la revendication 2, caractérisé en ce que la capacité de la batterie (22) supplémentaire de condensateurs susceptible d'être commandée est nettement plus petite que la capacité de la batterie (12) de condensateurs susceptible d'être commandée.

4. Circuit interrupteur (8) selon la revendication 1, caractérisé en ce que la branche de roue libre comporte une diode (26).

5. Circuit interrupteur (8) selon la revendication 1, caractérisé en ce qu'en tant que batterie (12) de condensateurs susceptible d'être commandée, il est prévu un circuit (38) en pont commandé dont les bornes (56, 58) du côté courant continu sont reliées l'une à l'autre de façon électriquement conductrice par l'intermédiaire d'un condensateur (32), et dont les bornes (48, 50) du côté courant alternatif le sont par un enroulement primaire (52) d'un transformateur toroïdal (54), et la branche (24) de roue libre est constituée d'un circuit série d'une diode (26) et d'un enroulement secondaire (60) du transformateur toroïdal (54).

6. Circuit interrupteur (8) selon la revendication 5, caractérisé en ce que l'inductance (Lσ) de dispersion du transformateur toroïdal (54) est prévue en tant qu'inductance (L_{G}) du circuit de commande.
